(19) Europäisches Patentamt
European Patent Office
Office européen des brevets

(11) **EP 4 421 876 A1**

(12) **EUROPEAN PATENT APPLICATION**
published in accordance with Art. 153(4) EPC

(43) Date of publication:
**28.08.2024 Bulletin 2024/35**

(21) Application number: **22877674.6**

(22) Date of filing: **28.09.2022**

(51) International Patent Classification (IPC):
***H01L 29/74*** *(2006.01)*

(52) Cooperative Patent Classification (CPC):
**H01L 29/0696; H01L 29/1016; H01L 29/102;
H01L 29/744**

(86) International application number:
**PCT/JP2022/036134**

(87) International publication number:
**WO 2023/067997 (27.04.2023 Gazette 2023/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **20.10.2021 JP 2021171705**

(71) Applicant: **Shindengen Electric Manufacturing
Co., Ltd.
Tokyo 100-0004 (JP)**

(72) Inventors:
• **ENDO, Kanae**
  **Asaka City, Saitama 3518503 (JP)**
• **INOUE, Tadashi**
  **Asaka City, Saitama 3518503 (JP)**
• **SHIBATA, Yukihiro**
  **Asaka City, Saitama 3518503 (JP)**

(74) Representative: **Herrero & Asociados, S.L.
Edificio Aqua - Agustín de Foxá, 4-10
28036 Madrid (ES)**

(54) **THYRISTOR AND METHOD FOR MANUFACTURING SAME**

(57) There is provided a thyristor with desensitized gate sensitivity. The invention includes: a first P-type semiconductor layer; a first N-type semiconductor layer disposed in contact with the first P-type semiconductor layer; a second P-type semiconductor layer disposed in contact with the first N-type semiconductor layer; a second N-type semiconductor layer disposed in contact with the second P-type semiconductor layer; a third P-type semiconductor layer that is disposed in contact with the second P-type semiconductor layer and has an impurity concentration higher than that of the second P-type semiconductor layer; a gate electrode; a cathode electrode; and a fourth P-type semiconductor layer that is in contact with each of the second P-type semiconductor layer and the second N-type semiconductor layer and has an impurity concentration higher than that of the second P-type semiconductor layer. The third P-type semiconductor layer and the fourth P-type semiconductor layer are separated from each other by the second P-type semiconductor layer, and the third P-type semiconductor layer and the second N-type semiconductor layer are separated from each other by the second P-type semiconductor layer.

*FIG. 1*

EP 4 421 876 A1

## Description

## <u>CROSS REFERENCE TO RELATED APPLICATION</u>

This patent application claims the benefit and priority of Japanese Patent Application No. 2021-171705 filed on October 20, 2021, the disclosure of which is incorporated by reference herein in its entirety as part of the present application.

## TECHNICAL FIELD

The present invention relates to a thyristor and a method for manufacturing the same.

## BACKGROUND ART

A conventional thyristor is used in a protection circuit to prevent an inrush current when an LED light is turned on.

However, there are cases where gate sensitivity increases when changing to highly reliable passivation. In a protection circuit for preventing an inrush current using such a thyristor, there is a possibility that an abnormal operation may occur or malfunction may occur due to minute noise. For this reason, a thyristor with low gate sensitivity is required. A technique related to this is disclosed in Japanese Patent Application Publication No. 2005-142518.

## SUMMARY OF INVENTION

PROBLEMS TO BE SOLVED

Various aspects of the present invention have an object to provide a thyristor with desensitized gate sensitivity and a method for manufacturing the same.

SOLUTION TO PROBLEM

Hereinafter, various aspects of the invention will be described.

[1] A thyristor, including:

a first P-type semiconductor layer;
a first N-type semiconductor layer disposed in contact with the first P-type semiconductor layer;
a second P-type semiconductor layer that is disposed in contact with the first N-type semiconductor layer and is separated from the first P-type semiconductor layer;
a second N-type semiconductor layer disposed in contact with the second P-type semiconductor layer;
a third P-type semiconductor layer that is disposed in contact with the second P-type semiconductor layer and has an impurity concentration higher than that of the second P-type semiconductor layer;
a gate electrode electrically connected to the third P-type semiconductor layer;
a cathode electrode electrically connected to the second N-type semiconductor layer; and
a fourth P-type semiconductor layer that is in contact with each of the second P-type semiconductor layer and the second N-type semiconductor layer, is disposed below the cathode electrode, and has an impurity concentration higher than that of the second P-type semiconductor layer,
wherein the third P-type semiconductor layer and the fourth P-type semiconductor layer are separated from each other by the second P-type semiconductor layer, and
the third P-type semiconductor layer and the second N-type semiconductor layer are separated from each other by the second P-type semiconductor layer.

[2] The thyristor according to [1] described above, in which the fourth P-type semiconductor layer is disposed on the third P-type semiconductor layer side in plan view.

[3] The thyristor according to [1] or [2] described above, in which a first PN junction is formed between the fourth P-type semiconductor layer and a part of a bottom portion of the second N-type semiconductor layer, a second PN junction is formed between the second P-type semiconductor layer and a first bottom portion of the second N-type semiconductor layer other than the part of the bottom portion, and the first PN junction is located closer to the gate electrode side than the second PN junction in plan view.

[4] The thyristor according to any one of [1] to [3] described above, in which the fourth P-type semiconductor layer is disposed so as to cover a part of a bottom portion of the second N-type semiconductor layer and a side portion of the second N-type semiconductor layer on the gate electrode side.

[5] The thyristor according to [1] or [2] described above, in which a first PN junction is formed between the fourth P-type semiconductor layer and a part of a bottom portion of the second N-type semiconductor layer, a second PN junction is formed between the second P-type semiconductor layer and a first bottom portion of the second N-type semiconductor layer other than the part of the bottom portion, a third PN junction is formed between the second P-type semiconductor layer and a second bottom portion of the second N-type semiconductor layer other than the part of the bottom portion, an impurity concentration of the part of the bottom portion of the second N-type semiconductor layer is higher than that of each of the first and second bottom portions, and in plan view, the first PN junction is located closer to the gate electrode side than the second PN junction, and the third PN junction is located closer to the gate electrode side than the first PN junction.

[6] The thyristor according to any one of [1], [2], and [5] described above, in which the fourth P-type semiconductor layer is disposed so as to cover a part of a bottom portion of the second N-type semiconductor layer and so as not to cover a side portion of the second N-type semiconductor layer on the gate electrode side.

[7] The thyristor according to any one of [1] to [6] described above, in which an impurity concentration of the second N-type semiconductor layer is higher in a portion in contact with the fourth P-type semiconductor layer than in a portion not in contact with the fourth P-type semiconductor layer.

[8] The thyristor according to any one of [1] to [7] described above, in which a ratio of an area of the fourth P-type semiconductor layer in contact with the second N-type semiconductor layer to an area of the second N-type semiconductor layer in plan view is 10% or more and 99% or less.

[9] A thyristor manufacturing method, including:

a step of forming a first P-type semiconductor layer below a first N-type semiconductor layer and forming a second P-type semiconductor layer on the first N-type semiconductor layer;
a step of forming a third P-type semiconductor layer and a fourth P-type semiconductor layer on a surface side of the second P-type semiconductor layer;
a step of forming a second N-type semiconductor layer on the surface side of the second P-type semiconductor layer so as to partially overlap the fourth P-type semiconductor layer; and
a step of forming a gate electrode on the third P-type semiconductor layer and forming a cathode electrode on the second N-type semiconductor layer.

[10] The thyristor manufacturing method according to [9] described above, in which the third P-type semiconductor layer has an impurity concentration higher than that of the second P-type semiconductor layer, the fourth P-type semiconductor layer is formed below the cathode electrode and has an impurity concentration higher than that of the second P-type semiconductor layer, the third P-type semiconductor layer and the fourth P-type semiconductor layer are separated from each other by the second P-type semiconductor layer, and the third P-type semiconductor layer and the second N-type semiconductor layer are separated from each other by the second P-type semiconductor layer.

EFFECT OF THE INVENTION

According to various aspects of the invention, it is possible to provide a thyristor with desensitized gate sensitivity and a method of manufacturing the same.

Details will be described below.

According to the thyristor of the above [1] of the invention, since the third P-type semiconductor layer, which is connected to the gate electrode and has an impurity concentration higher than that of the second P-type semiconductor layer, and the fourth P-type semiconductor layer, which is in contact with each of the second P-type semiconductor layer and the second N-type semiconductor layer, is disposed below the cathode electrode, and has an impurity concentration higher than that of the second P-type semiconductor layer, are provided, it is possible to desensitize the gate sensitivity of the thyristor.

According to the thyristor of the above [2] of the invention, since the fourth P-type semiconductor layer is disposed on the third P-type semiconductor layer side in plan view, it is possible to further desensitize the gate sensitivity of the thyristor.

According to the thyristor of the above [3] of the invention, since the first PN junction is located closer to the gate electrode side than the second PN junction in plan view, it is possible to further desensitize the gate sensitivity of the thyristor.

According to the thyristor of the above [4] of the invention, since the fourth P-type semiconductor layer is disposed so as to cover a part of the bottom portion of the second N-type semiconductor layer and the side portion of the second N-type semiconductor layer on the gate electrode side, it is possible to further desensitize the gate sensitivity of the thyristor.

**BRIEF DESCRIPTION OF DRAWINGS**

Fig. 1 is a cross-sectional view showing a thyristor according to one aspect of the invention;
Fig. 2A is a plan view of a fourth P-type semiconductor layer (second second base layer: $P^{++}$) 15b on the surface side of the thyristor shown in Fig. 1, and Fig. 2B is a plan view showing a second N-type semiconductor layer (emitter layer: $N^+$) 14 on the surface side of the thyristor shown in Fig. 1;
Fig. 3 is a cross-sectional view showing a thyristor according to one aspect of the invention;
Fig. 4A is a plan view of a fourth P-type semiconductor layer (second second base layer: $P^{++}$) 15b on the surface side of the thyristor shown in Fig. 3, and Fig. 4B is a plan view showing a second N-type semiconductor layer (emitter layer: $N^+$) 14 on the surface side of the thyristor shown in Fig. 3;
Fig. 5 is a partial cross-sectional view of the vicinity of the emitter layer ($N^+$) 14 enlarged to explain the impurity concentration of the second N-type semiconductor layer (emitter layer: $N^+$) 14 in the thyristor shown in Fig. 1; and

Fig. 6 is a diagram showing the dv/dt resistance of each thyristor sample of a structure 1 of the invention, a structure 2 of the invention, and a conventional structure.

## DESCRIPTION OF EMBODIMENTS

Hereinafter, embodiments of the invention will be described in detail with reference to the drawings. However, the invention is not limited to the following description, and those skilled in the art will readily understand that various changes in forms and details can be made without departing from the spirit and scope of the invention. Therefore, the invention should not be construed as being limited to the descriptions of the embodiments below.

(First embodiment)

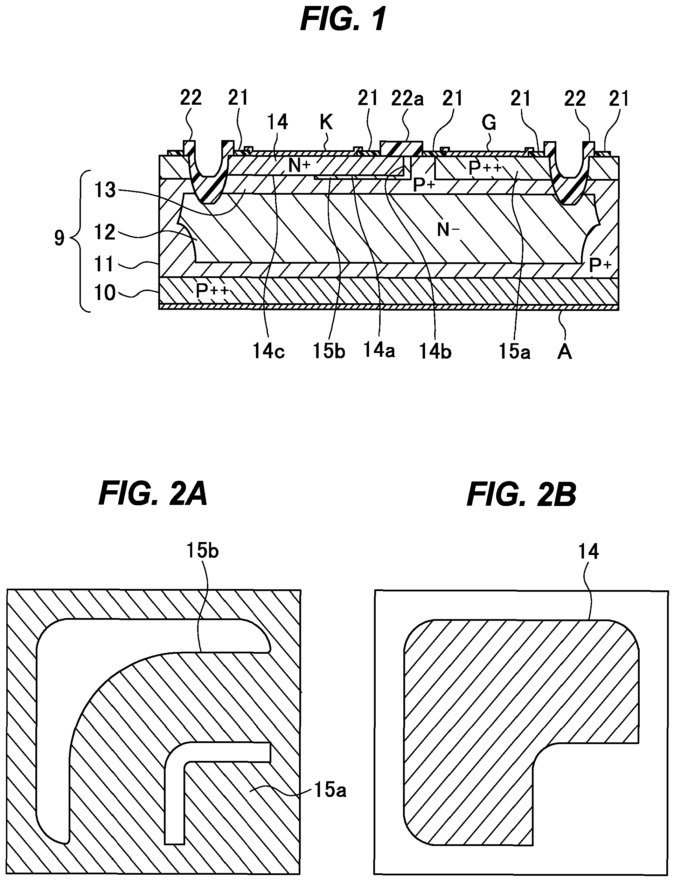

Fig. 1 is a cross-sectional view showing a thyristor according to one aspect of the invention. Fig. 2A is a plan view of a fourth P-type semiconductor layer (second second base layer: $P^{++}$) 15b on the surface side of the thyristor shown in Fig. 1, and Fig. 2B is a plan view showing a second N-type semiconductor layer (emitter layer: $N^+$) 14 on the surface side of the thyristor shown in Fig. 1. In plan view in which the thyristor shown in Fig. 1 is viewed from above, a plurality of layers overlap each other. Therefore, in order to make Figs. 2A and 2B easier to understand, a case of a plan view of a specific layer is shown.

The thyristor of the above [1] according to one aspect of the invention includes: a first P-type semiconductor layer ($P^+$) 11; a first N-type semiconductor layer ($N^-$) 12 that is disposed in contact with the first P-type semiconductor layer ($P^+$) 11 and is separated from the first P-type semiconductor layer ($P^+$) 11; a second P-type semiconductor layer ($P^+$) 13 disposed in contact with the first N-type semiconductor layer ($N^-$) 12; a second N-type semiconductor layer ($N^+$) 14 disposed in contact with the second P-type semiconductor layer 13; a third P-type semiconductor layer ($P^{++}$) 15a that is disposed in contact with the second P-type semiconductor layer ($P^+$) 13 and has an impurity concentration higher than that of the second P-type semiconductor layer ($P^+$) 13; a gate electrode G electrically connected to the third P-type semiconductor layer ($P^{++}$) 15a; a cathode electrode K electrically connected to the second N-type semiconductor layer ($N^+$) 14; and a fourth P-type semiconductor layer ($P^{++}$) 15b that is in contact with each of the second P-type semiconductor layer ($P^+$) 13 and the second N-type semiconductor layer ($N^+$) 14, is disposed below the cathode electrode K, and has an impurity concentration higher than that of the second P-type semiconductor layer ($P^+$) 13. The third P-type semiconductor layer ($P^{++}$) 15a and the fourth P-type semiconductor layer ($P^{++}$) 15b are separated from each other by the second P-type semiconductor layer ($P^+$) 13, and the third P-type semiconductor layer ($P^{++}$) 15a and the second N-type semiconductor layer ($N^+$) 14 are separated from each other by the second P-type semiconductor layer ($P^+$) 13.

Details will be described below.

The thyristor shown in Fig. 1 has an N-type semiconductor wafer 9, and the N-type semiconductor wafer 9 has the first P-type semiconductor layer ($P^+$) 11. In addition, Figs. 1, 2A and 2B show one thyristor chip after the N-type semiconductor wafer 9 is cut by dicing.

As shown in Fig. 1, on the first P-type semiconductor layer ($P^+$) 11, the first N-type semiconductor layer ($N^-$) 12 is disposed so as to be in contact with the first P-type semiconductor layer ($P^+$) 11.

On the first N-type semiconductor layer ($N^-$) 12, the second P-type semiconductor layer (first base layer: $P^+$) 13 is disposed so as to be in contact with the first N-type semiconductor layer ($N^-$) 12. In addition, the concentrations of the first P-type semiconductor layer ($P^+$) 11 and the second P-type semiconductor layer ($P^+$) 13 may be the same, or either may be higher. In addition, the concentration range of each of the first P-type semiconductor layer ($P^+$) 11 and the second P-type semiconductor layer ($P^+$) 13 may be between $1 \times 10^{16}$ atoms·cm$^{-3}$ and $5 \times 10^{18}$ atoms·cm$^{-3}$.

On the second P-type semiconductor layer (first base layer: $P^+$) 13, the second N-type semiconductor layer (emitter layer: $N^+$) 14 is disposed so as to be in contact with the second P-type semiconductor layer (first base layer: $P^+$) 13. The planar shape of the emitter layer ($N^+$) 14 is shown in Fig. 2B.

In addition, on the second P-type semiconductor layer (first base layer: $P^+$) 13, the third P-type semiconductor layer (first second base layer: $P^{++}$) 15a is disposed so as to be in contact with the second P-type semiconductor layer (first base layer: $P^+$) 13. The first second base layer ($P^{++}$) 15a has a higher impurity concentration than the first base layer ($P^+$) 13.

A gate electrode G is electrically connected on the third P-type semiconductor layer ($P^{++}$) 15a. The gate electrode G is preferably formed of Al.

A cathode electrode K is electrically connected on the second N-type semiconductor layer ($N^+$) 14. The cathode electrode K is preferably formed of Al.

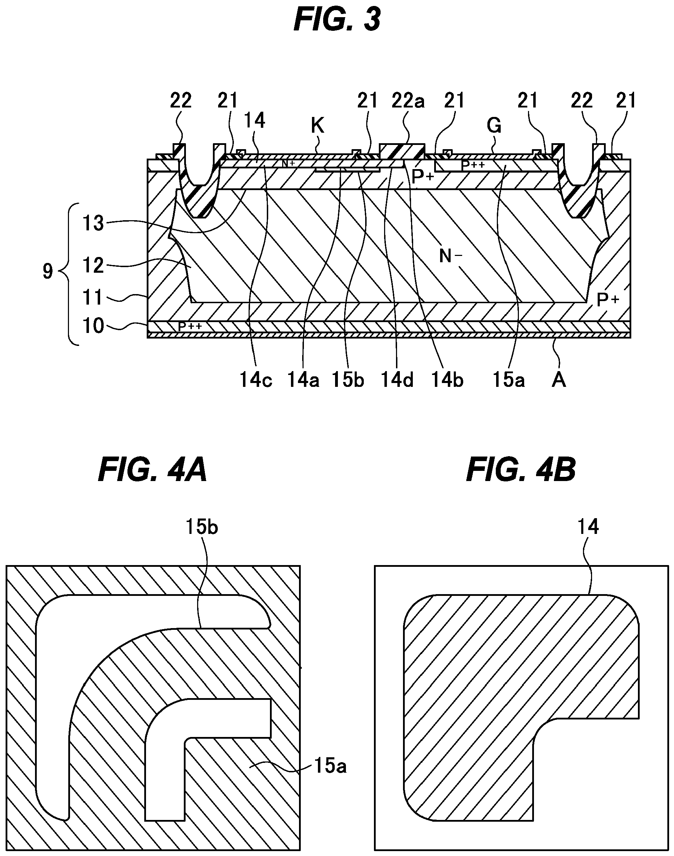

On the second P-type semiconductor layer (first base layer: $P^+$) 13, the fourth P-type semiconductor layer (second second base layer: $P^{++}$) 15b in contact with each of the first base layer 13 and the second N-type semiconductor layer (emitter layer: $N^+$) 14 is disposed. The second second base layer ($P^{++}$) 15b is disposed below the cathode electrode K (see Figs. 2A, 2B and 3). In addition, the second second base layer ($P^{++}$) 15 b has a higher impurity concentration than the first base layer ($P^+$) 13. The planar shape of the second second base layer ($P^{++}$) 15b is shown in Fig. 2A.

The third P-type semiconductor layer (first second base layer: P$^{++}$) 15a and the fourth P-type semiconductor layer (second second base layer: P$^{++}$) 15b are separated from each other by the second P-type semiconductor layer (first base layer: P$^{+}$) 13. In addition, the first second base layer (P$^{++}$) 15a and the second N-type semiconductor layer (emitter layer: N$^{+}$) 14 are separated from each other by the first base layer (P$^{+}$) 13.

In addition, as shown in Fig. 1, an SiO$_2$ film 21 is formed on the emitter layer (N$^{+}$) 14, the first base layer (P$^{+}$) 13, and the first second base layer (P$^{++}$) 15a. The cathode electrode K is formed on the emitter layer (N$^{+}$) 14 and the SiO$_2$ film 21. The gate electrode G is formed on the first second base layer (P$^{++}$) 15a and the SiO$_2$ film 21. In addition, a glass passivation film 22 is formed at each end of the first N-type semiconductor layer (N$^{-}$) 12, the first base layer (P$^{+}$) 13, the emitter layer (N$^{+}$) 14, and the first second base layer (P$^{++}$) 15a. In addition, the glass passivation film 22a is formed between the cathode electrode K and the gate electrode G.

According to the present embodiment, since the first second base layer (P$^{++}$) 15a, which is connected to the gate electrode G and has an impurity concentration higher than that of the first base layer (P$^{+}$) 13, and the second second base layer (P$^{++}$) 15b, which is in contact with each of the first base layer (P$^{+}$) 13 and the emitter layer (N$^{+}$) 14, is disposed below the cathode electrode K, and has an impurity concentration higher than that of the first base layer (P$^{+}$) 13, are provided, it is possible to desensitize the gate sensitivity of the thyristor. As a result, even when this thyristor is used in a protection circuit for preventing an inrush current when an LED light is turned on, for example, it is possible to suppress an abnormal operation of the protection circuit for preventing an inrush current or the occurrence of malfunction due to minute noise. In addition to this, the critical off-voltage rise rate dv/dt resistance also increases. Details thereof will be described later.

In addition, by separating the first second base layer (P$^{++}$) 15a and the second second base layer (P$^{++}$) 15b from each other by the first base layer 13, it is possible to further desensitize the gate sensitivity of the thyristor.

The reason why the above-described dv/dt resistance also increases is as follows.

A thyristor requires a G (gate) current to turn on between A and K (between the anode A and the cathode K). When a positive voltage is applied to the anode A without turning on the thyristor, a depletion layer at a junction between the first N-type semiconductor layer (N$^{-}$) 12 and the first base layer (P$^{+}$) 13 shown in Fig. 1 expands. This is the capacitance C of a condenser. Electrons move inside the thyristor to charge the capacitance C of the condenser. This charge current behaves the same as the G current. This current i is determined by the following equation.

$$i = C \cdot (dv/dt)$$

Therefore, since the current increases as the dv/dt value increases, the on operation (malfunction) is likely to occur even if the G current is not supplied.

Therefore, by desensitizing the gate sensitivity, it is possible to realize a structure that has a high dv/dt value and is difficult to turn on even when a large charge current flows.

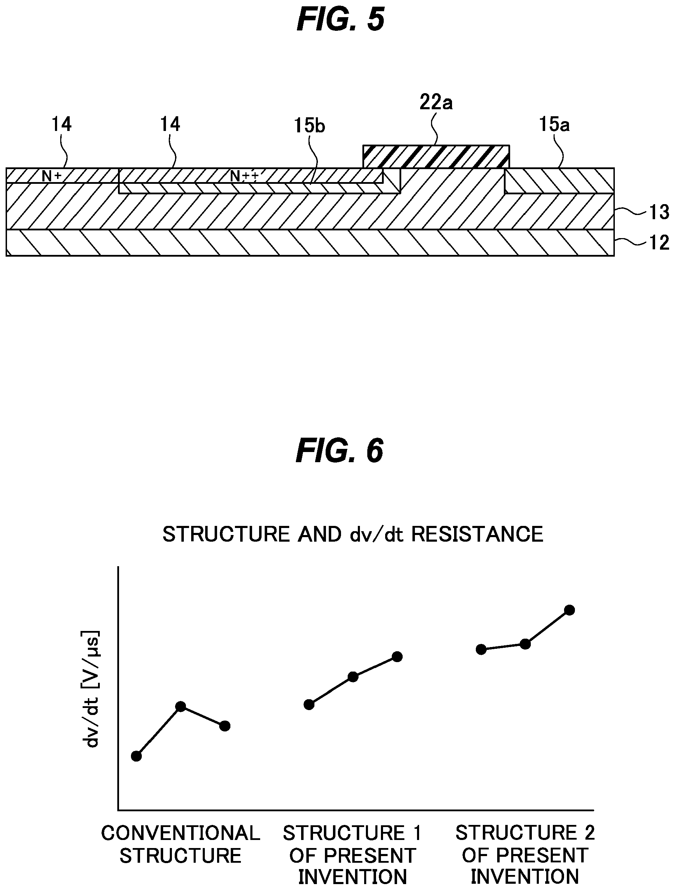

Fig. 6 is a diagram showing the dv/dt resistance of each thyristor sample of a structure 1 of the invention, a structure 2 of the invention, and a conventional structure. The structure 1 of the invention and the structure 2 of the invention are thyristors having the structure shown in Fig. 1. The structure 2 of the invention is only different from the structure 1 of the invention in that the ratio of the area of the second second base layer (P$^{++}$) 15b shown in Fig. 2A in contact with the emitter layer (N$^{+}$) 14 to the area of the emitter layer (N$^{+}$) 14 shown in Fig. 2B in the thyristor according to one aspect of the invention shown in Fig. 1 is larger than that in the structure 1 of the invention, and the other points are the same. The conventional structure is different from the structure 1 of the invention and the structure 2 of the invention in that there is no second second base layer (P$^{++}$) 15b shown in Fig. 1, and the other points are the same.

As shown in Fig. 6, it was confirmed that the presence of the second second base layer (P$^{++}$) 15b increased the dv/dt resistance, and it was confirmed that the dv/dt resistance increased as the area of the second second base layer (P$^{++}$) 15b in contact with the emitter layer (N$^{+}$) 14 increased.

In addition, in plan view, the fourth P-type semiconductor layer (second second base layer: P$^{++}$) 15b is disposed on the third P-type semiconductor layer (first second base layer: P$^{++}$) 15a side (see Figs. 1, 2A, 2B, 3, 4A and 4B). In this manner, it is possible to further desensitize the gate sensitivity of the thyristor.

As shown in Fig. 1, a first PN junction is formed between the fourth P-type semiconductor layer (second second base layer: P$^{++}$) 15b and a part 14a of a bottom portion of the second N-type semiconductor layer (emitter layer: N$^{+}$) 14. In addition, a second PN junction is formed between the second P-type semiconductor layer (first base layer: P$^{+}$) 13 and a bottom portion 14c of the emitter layer (N$^{+}$) 14 other than the part 14a of the bottom portion.

In plan view, the first PN junction is located closer to the gate electrode G side than the second PN junction (see Fig. 1). In this manner, it is possible to further desensitize the gate sensitivity of the thyristor. As a result, even when this thyristor is used in a protection circuit for preventing an inrush current when an LED light is turned on, for example, it is possible to suppress an abnormal operation of the protection circuit for preventing an inrush current or the occurrence of malfunction due to minute noise. In addition to this, the critical off-voltage rise rate dv/dt resistance also increases.

The fourth P-type semiconductor layer (second second base layer: P$^{++}$) 15b is disposed so as to cover the part 14a of the bottom portion of the second N-type semiconductor layer (emitter layer: N+) 14 and a side portion 14b on the gate electrode G side. In this manner, it is possible to further desensitize the gate sensitivity of the thyristor. Therefore, even when this thyristor is used in a protection circuit for preventing an inrush current when an LED light is turned on, for example, it is possible to suppress an abnormal operation of the protection circuit for preventing an inrush current or the occurrence of malfunction due to minute noise. In addition to this, the critical off-voltage rise rate dv/dt resistance also increases.

Fig. 5 is a partial cross-sectional view of the vicinity of the emitter layer (N+) 14 enlarged to explain the impurity concentration of the second N-type semiconductor layer (emitter layer: N+) 14 in the thyristor shown in Fig. 1.

The impurity concentration of the second N-type semiconductor layer (emitter layer: N+) 14 is higher in a portion in contact with the fourth P-type semiconductor layer (second second base layer: P++) 15b than in a portion not in contact with the fourth P-type semiconductor layer (second second base layer: P++) 15b. Specifically, the impurity concentration of the second N-type semiconductor layer (N++) 14 located on the second second base layer (P++) 15b is higher than the impurity concentration of the second N-type semiconductor layer (N+) 14 below which the second second base layer (P++) 15b is not present. In addition, as shown in Fig. 5, this semiconductor device (thyristor) has a structure including the second N-type semiconductor layer (N++) 14, the second second base layer (P++) 15b, and an NPN-Tr at a junction between the second P-type semiconductor layer (first base layer: P+) 13 and the first N-type semiconductor layer (N-) 12. By adopting such a structure shown in Fig. 5, it is possible to change the NPN-Tr current gain. Therefore, after desensitizing the gate sensitivity, it becomes easier to adjust the sensitivity.

In plan view, as shown in Figs. 2A and 2B, the ratio of the area of the fourth P-type semiconductor layer (second second base layer: P++) 15b in contact with the second N-type semiconductor layer (N+) 14 to the area of the second N-type semiconductor layer (emitter layer: N+) 14 is preferably 10% or more and 99% or less. In this manner, it is possible to further desensitize the gate sensitivity of the thyristor. As a result, even when this thyristor is used in a protection circuit for preventing an inrush current when an LED light is turned on, for example, it is possible to suppress an abnormal operation of the protection circuit for preventing an inrush current or the occurrence of malfunction due to minute noise. In addition to this, the critical off-voltage rise rate dv/dt resistance also increases.

(Second embodiment)

Fig. 3 is a cross-sectional view showing a thyristor according to one aspect of the invention, and the same parts as in Fig. 1 are denoted by the same reference numerals and explanations thereof will be omitted.

A first PN junction is formed between a fourth P-type semiconductor layer (P++) 15b and a part (N++) 14a of a bottom portion of a second N-type semiconductor layer (N+) 14. In addition, a second PN junction is formed between a second P-type semiconductor layer (P+) 13 and a first bottom portion (N+) 14c of the second N-type semiconductor layer (N+) 14 other than the part 14a of bottom portion. In addition, a third PN junction is formed between the second P-type semiconductor layer (P+) 13 and a second bottom portion (N+) 14d of the second N-type semiconductor layer (N+) 14 other than the part 14a of bottom portion. The impurity concentration of the part (N++) 14a of the bottom portion of the second N-type semiconductor layer (N+) 14 is higher than that of each of the first and second bottom portions (N+) 14c and 14d. In plan view, the first PN junction is located closer to the gate electrode G side than the second PN junction, and the third PN junction is located closer to the gate electrode G side than the first PN junction.

Details will be described below.

As shown in Fig. 3, a first PN junction is formed between the fourth P-type semiconductor layer (second second base layer: P++) 15b and the part (N++) 14a of the bottom portion of the second N-type semiconductor layer (emitter layer: N+) 14. In addition, a second PN junction is formed between the second P-type semiconductor layer (first base layer: P+) 13 and the first bottom portion (N+) 14c of the emitter layer (N+) 14 other than the part 14a of the bottom portion. In addition, a third PN junction is formed between the first base layer (P+) 13 and the second bottom portion (N+) 14d of the emitter layer (N+) 14 other than the part 14a of the bottom portion.

The impurity concentration of the part (N++) 14a of the bottom portion of the second N-type semiconductor layer (N+) 14 is higher than that of each of the first and second bottom portions (N+) 14c and 14d (see Figs. 3 and 5). This is because the manufacturing is based on a manufacturing method described in a third embodiment, which will be described later. In addition, reference numeral 15b in Fig. 5 corresponds to reference numeral 15b in Fig. 1.

Also in the present embodiment, it is possible to obtain the same effects as in the first embodiment.

In addition, in plan view, the first PN junction is located closer to the gate electrode G side than the second PN junction (see Fig. 3). With such a structure, it is possible to adjust the gate characteristics.

The fourth P-type semiconductor layer (second second base layer: P++) 15b shown in Fig. 3 is disposed so as to cover the part 14a of the bottom portion of the second N-type semiconductor layer (emitter layer: N+) 14 and so as not to cover the side portion 14b on the gate electrode G side.

According to the present embodiment, since the second second base layer (P++) 15b covers the part 14a of the bottom portion of the emitter layer (N+) 14, it is possible to further desensitize the gate sensitivity of the thyristor. Therefore, even when this thyristor is used in a protection circuit for preventing an inrush current when an LED light is turned on, for example, it is possible to suppress an abnormal operation of the protection circuit for preventing an inrush current or the occurrence of malfunction due to minute noise. In addition to this, the critical off-voltage rise rate dv/dt resistance also increases.

(Third embodiment: thyristor manufacturing method)

The thyristor manufacturing method of the above [9] according to one aspect of the invention includes: a step of forming a first P-type semiconductor layer (P$^+$) 11 below a first N-type semiconductor layer (N$^-$) 12 and forming a second P-type semiconductor layer (P$^+$) 13 on the first N-type semiconductor layer (N$^-$) 12; a step of forming a third P-type semiconductor layer (P$^{++}$) 15a and a fourth P-type semiconductor layer (P$^{++}$) 15b on a surface side of the second P-type semiconductor layer (P$^+$) 13; a step of forming a second N-type semiconductor layer (N$^+$, N$^{++}$) 14 on the surface side of the second P-type semiconductor layer (P$^+$) 13 so as to partially overlap the fourth P-type semiconductor layer (P$^{++}$) 15b; and a step of forming a gate electrode G on the third P-type semiconductor layer (P$^{++}$) 15a and forming a cathode electrode K on the second N-type semiconductor layer (N$^+$) 14.

Details will be described below.

First, as shown in Fig. 1, the N-type semiconductor wafer 9 is prepared.

Then, isolation regions (regions on both sides of the first N-type semiconductor layer (N$^-$) 12) are formed to partition the N-type semiconductor wafer 9 into a plurality of thyristor forming regions. In addition, Figs. 1 and 3 show one thyristor chip after the N-type semiconductor wafer 9 is cut by dicing. In addition, the N-type semiconductor wafer 9 includes the first N-type semiconductor layer (N$^-$) 12.

Here, the method for forming the isolation regions described above is to introduce P$^+$-type impurities from both surfaces of the N-type semiconductor wafer 9 (a surface on the second N-type semiconductor layer (emitter layer: N$^+$) 14 side and a surface on the opposite side thereof) by using a deposition method and diffuse the P$^+$-type impurities.

Then, P$^+$-type impurities are introduced from both the surfaces of the N-type semiconductor wafer 9 described above by using a deposition method and diffused. As a result, the first P-type semiconductor layer (P$^+$) 11 is formed below the first N-type semiconductor layer (N$^-$) 12, and the second P-type semiconductor layer (first base layer: P$^+$) 13 is formed on the first N-type semiconductor layer (N$^-$) 12.

Then, after forming a mask (not shown) on the second P-type semiconductor layer (P$^+$) 13, P-type impurities are introduced into both the surfaces of the semiconductor wafer 9 by using a deposition method and diffused. As a result, the third P-type semiconductor layer (first second base layer: P$^{++}$) 15a and the fourth P-type semiconductor layer (second second base layer: P$^{++}$) 15b are formed on the surface side of the first base layer (P$^+$) 13, and a fifth P-type semiconductor layer (P$^{++}$) 10 is formed on the back side of the first P-type semiconductor layer (P$^+$) 11.

Then, after removing the above-described mask and forming a mask (not shown) on the surface of the second P-type semiconductor layer (first base layer: P$^+$) 13, N-type impurities are introduced into the first base layer (P$^+$) 13 by using a deposition method and diffused. As a result, the second N-type semiconductor layer (emitter layer: N$^+$) 14 is formed on the surface side of the first base layer (P$^+$) 13 so as to partially overlap the fourth P-type semiconductor layer (second second base layer: P$^{++}$) 15b (see Figs. 1, 2A, and 2B).

Then, the above-described mask is removed, and a mask (not shown) is formed on the surface of the first base layer (P$^+$) 13. This mask has an opening in the second second base layer 15b except for the fourth P-type semiconductor layer (first second base layer: P$^{++}$) 15a side. Then, N-type impurities are introduced into the first base layer (P$^+$) 13 by using a deposition method and diffused. As a result, as shown in Fig. 5, the second N-type semiconductor layer (emitter layer: N$^{++}$) 14 is formed on the surface side of the second second base layer (P$^{++}$) 15b. In this manner, the second N-type semiconductor layer (N$^+$, N$^{++}$) 14 can be formed on the surface side of the first base layer (P$^+$) 13 so as to partially overlap the second second base layer 15b. After forming the second second base layer (P$^{++}$) 15b as described above, in order to make the surface side of the second second base layer (P$^{++}$) 15b into the opposite conductivity type emitter layer (N$^{++}$) 14, the emitter layer (N$^{++}$) 14 on the surface side of the second second base layer (P$^{++}$) 15b becomes a region with excessive N-type impurities, and the depth of this region should not be larger than that of the second second base layer (P$^{++}$) 15b. That is, a boundary portion 14a between the emitter layer (N$^{++}$) 14 and the second second base layer (P$^{++}$) 15b is slightly shallower than the second second base layer (P$^{++}$) 15b (see Fig. 5).

Then, the above-described mask is removed, and the gate electrode G is formed on the third P-type semiconductor layer (first second base layer: P$^{++}$) 15a. This gate electrode is electrically connected to the first second base layer (P$^{++}$) 15a.

Also in the present embodiment, it is possible to obtain the same effects as in the first embodiment.

In addition, according to the present embodiment, the first second base layer (P$^{++}$) 15a and the second second base layer (P$^{++}$) 15b can be formed on the surface side of the first base layer (P$^+$) 13 in the same process.

In addition, the third P-type semiconductor layer (first second base layer: P$^{++}$) 15a has an impurity concentration higher than that of the second P-type semiconductor layer (P$^+$) 13.

In addition, the fourth P-type semiconductor layer (second second base layer: P++) 15b is formed below the cathode electrode K and has an impurity concentration higher than that of the second P-type semiconductor layer (P+) 13.

In addition, the third P-type semiconductor layer (first second base layer: P++) 15a and the fourth P-type semiconductor layer (second second base layer: P++) 15b are separated from each other by the second P-type semiconductor layer (first base layer: P+) 13, and the first second base layer (P++) 15a and the second N-type semiconductor layer (emitter layer: N+) 14 are separated from each other by the first base layer (P+) 13.

According to the present embodiment, since the first second base layer (P++) 15a, which is connected to the gate electrode G and has an impurity concentration higher than that of the first base layer (P+) 13, and the second second base layer (P++) 15b, which is in contact with each of the first base layer (P+) 13 and the emitter layer (N+) 14, is disposed below the cathode electrode K, and has an impurity concentration higher than that of the first base layer (P+) 13, are provided, it is possible to desensitize the gate sensitivity of the thyristor.

EXPLANATION OF SYMBOLS

11 FIRST P-TYPE SEMICONDUCTOR LAYER (P+)
12 FIRST N-TYPE SEMICONDUCTOR LAYER (N-)
13 SECOND P-TYPE SEMICONDUCTOR LAYER (FIRST BASE LAYER: P+)
14 SECOND N-TYPE SEMICONDUCTOR LAYER (EMITTER LAYER: N+)
14a PART (N++) OF BOTTOM PORTION OF SECOND N-TYPE SEMICONDUCTOR LAYER (N+)
14b SIDE PORTION ON GATE ELECTRODE SIDE
14c FIRST BOTTOM PORTION (N+) OF SECOND N-TYPE SEMICONDUCTOR LAYER (N+) OTHER THAN PART OF BOTTOM PORTION
14d SECOND BOTTOM PORTION (N+) OF SECOND N-TYPE SEMICONDUCTOR LAYER OTHER THAN PART OF BOTTOM PORTION
15a THIRD P-TYPE SEMICONDUCTOR LAYER (FIRST SECOND BASE LAYER: P++)
15b FOURTH P-TYPE SEMICONDUCTOR LAYER (SECOND SECOND BASE LAYER: P++)
G GATE ELECTRODE
K CATHODE ELECTRODE

**Claims**

1. A thyristor, comprising:

a first P-type semiconductor layer;
a first N-type semiconductor layer disposed in contact with the first P-type semiconductor layer;

a second P-type semiconductor layer that is disposed in contact with the first N-type semiconductor layer and is separated from the first P-type semiconductor layer;
a second N-type semiconductor layer disposed in contact with the second P-type semiconductor layer;
a third P-type semiconductor layer that is disposed in contact with the second P-type semiconductor layer and has an impurity concentration higher than that of the second P-type semiconductor layer;
a gate electrode electrically connected to the third P-type semiconductor layer;
a cathode electrode electrically connected to the second N-type semiconductor layer; and
a fourth P-type semiconductor layer that is in contact with each of the second P-type semiconductor layer and the second N-type semiconductor layer, is disposed below the cathode electrode, and has an impurity concentration higher than that of the second P-type semiconductor layer,
wherein the third P-type semiconductor layer and the fourth P-type semiconductor layer are separated from each other by the second P-type semiconductor layer, and
the third P-type semiconductor layer and the second N-type semiconductor layer are separated from each other by the second P-type semiconductor layer.

2. The thyristor according to claim 1,
wherein the fourth P-type semiconductor layer is disposed on the third P-type semiconductor layer side in plan view.

3. The thyristor according to claim 1 or 2,

wherein a first PN junction is formed between the fourth P-type semiconductor layer and a part of a bottom portion of the second N-type semiconductor layer,
a second PN junction is formed between the second P-type semiconductor layer and a first bottom portion of the second N-type semiconductor layer other than the part of the bottom portion, and
the first PN junction is located closer to the gate electrode side than the second PN junction in plan view.

4. The thyristor according to claim 1 or 2,
wherein the fourth P-type semiconductor layer is disposed so as to cover a part of a bottom portion of the second N-type semiconductor layer and a side portion of the second N-type semiconductor layer on the gate electrode side.

**EP 4 421 876 A1**

5. The thyristor according to claim 1 or 2,

   wherein a first PN junction is formed between the fourth P-type semiconductor layer and a part of a bottom portion of the second N-type semiconductor layer,
   a second PN junction is formed between the second P-type semiconductor layer and a first bottom portion of the second N-type semiconductor layer other than the part of the bottom portion,
   a third PN junction is formed between the second P-type semiconductor layer and a second bottom portion of the second N-type semiconductor layer other than the part of the bottom portion,
   an impurity concentration of the part of the bottom portion of the second N-type semiconductor layer is higher than that of each of the first and second bottom portions, and
   in plan view, the first PN junction is located closer to the gate electrode side than the second PN junction, and the third PN junction is located closer to the gate electrode side than the first PN junction.

6. The thyristor according to claim 1 or 2,
   wherein the fourth P-type semiconductor layer is disposed so as to cover a part of a bottom portion of the second N-type semiconductor layer and so as not to cover a side portion of the second N-type semiconductor layer on the gate electrode side.

7. The thyristor according to claim 1 or 2,
   wherein an impurity concentration of the second N-type semiconductor layer is higher in a portion in contact with the fourth P-type semiconductor layer than in a portion not in contact with the fourth P-type semiconductor layer.

8. The thyristor according to claim 1 or 2,
   wherein a ratio of an area of the fourth P-type semiconductor layer in contact with the second N-type semiconductor layer to an area of the second N-type semiconductor layer in plan view is 10% or more and 99% or less.

9. A thyristor manufacturing method, comprising:

   a step of forming a first P-type semiconductor layer below a first N-type semiconductor layer and forming a second P-type semiconductor layer on the first N-type semiconductor layer;
   a step of forming a third P-type semiconductor layer and a fourth P-type semiconductor layer on a surface side of the second P-type semiconductor layer;
   a step of forming a second N-type semiconductor layer on the surface side of the second P-type semiconductor layer so as to partially overlap the fourth P-type semiconductor layer; and
   a step of forming a gate electrode on the third P-type semiconductor layer and forming a cathode electrode on the second N-type semiconductor layer.

10. The thyristor manufacturing method according to claim 9,

    wherein the third P-type semiconductor layer has an impurity concentration higher than that of the second P-type semiconductor layer,
    the fourth P-type semiconductor layer is formed below the cathode electrode and has an impurity concentration higher than that of the second P-type semiconductor layer,
    the third P-type semiconductor layer and the fourth P-type semiconductor layer are separated from each other by the second P-type semiconductor layer, and
    the third P-type semiconductor layer and the second N-type semiconductor layer are separated from each other by the second P-type semiconductor layer.

## FIG. 1

## FIG. 2A

## FIG. 2B

## FIG. 3

## FIG. 4A

## FIG. 4B

## FIG. 5

## FIG. 6

### STRUCTURE AND dv/dt RESISTANCE

dv/dt [V/μs]

CONVENTIONAL
STRUCTURE

STRUCTURE 1
OF PRESENT
INVENTION

STRUCTURE 2
OF PRESENT
INVENTION

## INTERNATIONAL SEARCH REPORT

International application No.

**PCT/JP2022/036134**

### A. CLASSIFICATION OF SUBJECT MATTER

***H01L 29/74***(2006.01)i
FI:   H01L29/74 F; H01L29/74 B

According to International Patent Classification (IPC) or to both national classification and IPC

### B. FIELDS SEARCHED

Minimum documentation searched (classification system followed by classification symbols)

H01L29/74

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 62-52967 A (FUJI ELECTRIC CO LTD) 07 March 1987 (1987-03-07)<br>p. 2, upper left column, line 13 to p. 2, lower left column, line 12, fig. 3 | 1-3, 6, 8-10 |
| A | | 4-5, 7 |
| X | JP 2019-169563 A (SHINDENGEN ELECTRIC MFG) 03 October 2019 (2019-10-03)<br>paragraphs [0027]-[0038], fig. 2 | 1 |
| A | | 2–10 |
| X | JP 2010-232564 A (SHINDENGEN ELECTRIC MFG) 14 October 2010 (2010-10-14)<br>paragraphs [0031]-[0032], fig. 1 | 1 |
| A | | 2–10 |
| A | JP 2000-31483 A (KANSAI ELECTRIC POWER CO INC) 28 January 2000 (2000-01-28) | 1-10 |
| A | JP 55-95363 A (NIPPON ELECTRIC CO) 19 July 1980 (1980-07-19) | 1-10 |
| A | JP 49-77585 A (HITACHI LTD) 26 July 1974 (1974-07-26) | 1-10 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 December 2022** | **13 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/036134**

| Patent document cited in search report | | | Publication date (day/month/year) | Patent family member(s) | Publication date (day/month/year) |
|---|---|---|---|---|---|
| JP | 62-52967 | A | 07 March 1987 | (Family: none) | |
| JP | 2019-169563 | A | 03 October 2019 | (Family: none) | |
| JP | 2010-232564 | A | 14 October 2010 | (Family: none) | |
| JP | 2000-31483 | A | 28 January 2000 | (Family: none) | |
| JP | 55-95363 | A | 19 July 1980 | (Family: none) | |
| JP | 49-77585 | A | 26 July 1974 | (Family: none) | |

Form PCT/ISA/210 (patent family annex) (January 2015)

**REFERENCES CITED IN THE DESCRIPTION**

**Patent documents cited in the description**

- JP 2021171705 A
- JP 2005142518 A